# EUROPÄISCHE PATENTSCHRIFT

(11) **EP 0 916 493 B1**
(45) Veröffentlichungstag und Bekanntmachung des Hinweises auf die Patenterteilung: **05.12.2001**
(21) Anmeldenummer: 98120097.5
(22) Anmeldetag: 24.10.1998
(51) Int. Cl.: B41F 35/02, B41C 1/10

(54) **Einrichtung zum Entwickeln von zylindrischen Oberflächen**
Device for developing cylindrical surfaces
Dispositif pour développer des surfaces cylindriques

(30) Priorität: 13.11.1997 DE 19750241
(43) Veröffentlichungstag der Anmeldung: 19.05.1999
(73) Patentinhaber: Koenig & Bauer Aktiengesellschaft, 97080 Würzburg (DE)
(72) Erfinder: Nerger, Reinhard, Dipl.-Ing., 01445 Radebeul (DE)

(56) Entgegenhaltungen:
- EP-A- 0 369 565
- DE-A- 19 600 844
- DE-C- 19 600 846
- US-A- 5 107 764
- US-A- 5 644 986
- PATENT ABSTRACTS OF JAPAN vol. 012, no. 197 (M-706), 8. Juni 1988 & JP 63 004947 A (DAINIPPON PRINTING CO LTD), 9. Januar 1988

## Beschreibung

Die Erfindung betrifft eine Einrichtung zum Entwickeln zylindrischer Oberflächen in Druckmaschinen mit mindestens einer integrierten Einrichtung zum Beschreiben/Bebildern von Wirkflächen eines Druckformzylinders.

Beim Beschreiben/Bebildern mittels einer speziellen in einer Druckmaschine integrierten Einrichtung bestehen üblicherweise die Wirkflächen des Druckformzylinders aus einer farbabweisenden Silikonschicht und einer farbführenden Bildschicht. Werden die Wirkflächen beschrieben/bebildert, wird die Silikonschicht an den erforderlichen Stellen in Partikel umgewandelt und damit die tieferliegende farbführende Schicht freigelegt. Die Silikonpartikel müssen in einem dem Beschreiben/Bebildern nachgeordneten Entwicklungsschritt entfernt werden, wobei in den tieferliegenden Zonen, insbesondere jedoch in den Randbereichen diese Silikonpartikel so partiell haften, daß ihre Entfernung problematisch ist.

Nach der DE 19600846 C1 ist eine Vorrichtung zum Entfernen der beim direkten Beschreiben/Bebildern entstehenden Silikonpartikel bekannt. Die Vorrichtung weist eine sich über die Breite der Druckform erstreckende weiche Gummileiste auf. In Drehrichtung des Druckformzylinders ist hinter der Gummileiste eine Einrichtung zum Absaugen gelöster Silikonpartikel vorgesehen, der eine Walze mit einer klebenden Oberfläche nachgeordnet ist. Es sind weiterhin Mittel vorgesehen zum Anfeuchten sowie zum traversierenden Verschieben der Gummileiste.

Die Einrichtung hat den Nachteil, daß aufgrund der in Drehrichtung des Druckformzylinders hintereinander angeordneten, über die Breite des Druckformzylinders reichende Arbeitsorgane Gummileiste, Absaugeinrichtung und Klebewalze ein großer Bauraum beansprucht und die Zugänglichkeit zum Druckformzylinder eingeschränkt wird. Außerdem ist es nachteilig, daß mit dieser Vorrichtung lediglich die in den Randbereichen der tieferliegenden Flächen nur angelösten Silikonpartikel sicher entfernt werden, die etwa in Umfangsrichtung verlaufen oder in axialer Richtung sowie in Drehrichtung des Druckformzylinders vorn liegen, so daß zusätzliche Möglichkeiten vorgesehen werden müssen, um sicherzustellen, daß auch die angelösten Silikonpartikel in den Randbereichen entfernt werden, die in axialer Richtung und in Drehrichtung des Druckzylinders hinten liegen.
Weiterhin ist aus der DE 19600844 eine Einrichtung zum Entfernen der beim direkten Beschreiben/Bebildern entstehenden Silikonpartikel bekannt, die aus einem sich über die Breite des Druckformzylinders erstreckenden Reinigungselement besteht, welches mit einem Kunststoffvlies versehen ist. Das Reinigungselement ist als zwangsläufig angetriebene Walze ausgebildet, die an den Druckformzylinder anstellbar und in eine Rastposition zurückführbar ist. Die Walze ist in einem Gehäuse angeordnet, welches einerseits durch eine Dichtlippe gegen den Umfang des Druckformzylinders abgedichtet und andererseits mit einer in Drehrichtung des Druckformzylinders hinter der Walze angeordneten Absaugeinrichtung versehen ist, durch die die von der Druckform gelösten Silikonpartikel abgesaugt werden. Diese Einrichtung beansprucht ebenfalls einen großen Bauraum und schränkt die Zugänglichkeit zum Druckformzylinder ein. Außerdem besteht die Gefahr, daß durch die das Gehäuse gegen den Druckformzylinder abdichtenden Dichtlippen die Qualität der Wirkflächen des Druckformzylinders nachteilig beeinflußt werden.

Aufgabe der Erfindung ist eine Vorrichtung zum Entwickeln von zylindrischen Oberflächen zu schaffen, die wenig Bauraum beansprucht und die Effektivität der Druckmaschine erhöht.

Erfindungsgemäß wird die Aufgabe durch die Patentansprüche gelöst.

Durch die erfindungsgemäße Lösung ist es möglich, die beim Beschreiben/Bebildern entstehenden Silikonpartikel oder sonstigen Verunreinigungen wirkungsvoll zu entfernen, wobei durch die Einrichtung wenig Bauraum beansprucht wird. Dabei gelangen die Wirkflächen des Druckformzylinders nicht oder nur in einem geringen Maß mit Arbeitsorganen in Wirkverbindung, so daß eine Beschädigung der Wirkflächen ausgeschlossen und damit die Effektivität der Maschine erhöht werden kann.

An einem Ausführungsbeispiel soll die Erfindung näher erläutert werden. In den zugehörigen Zeichnungen zeigen
- Fig.1: eine Seitenansicht eines Druckformzylinders mit einer erfindungsgemäßen Einrichtung
- Fig. 2: eine weitere Ausführungsform der Einrichtung
- Fig. 3: eine Ausführungsform der Einrichtung gem. Fig. 2 in einer perspektivischen Darstellung.

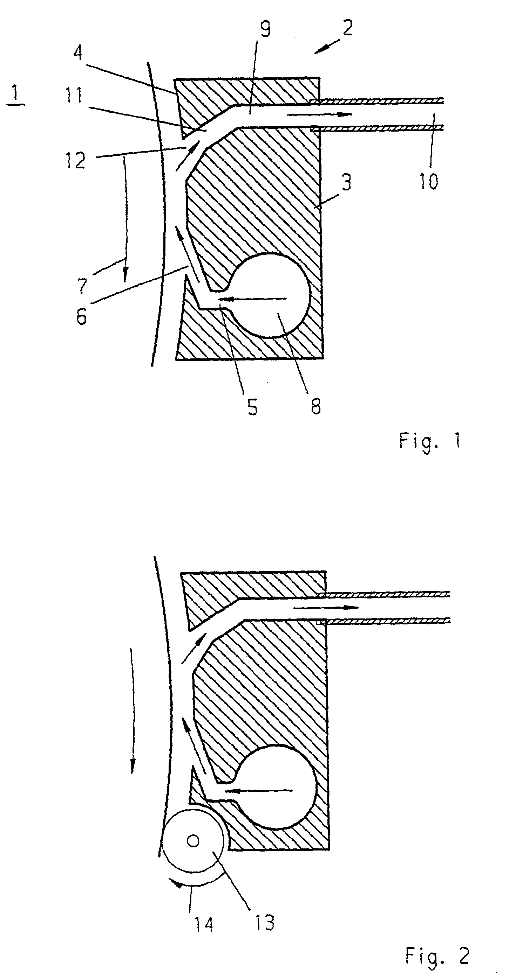

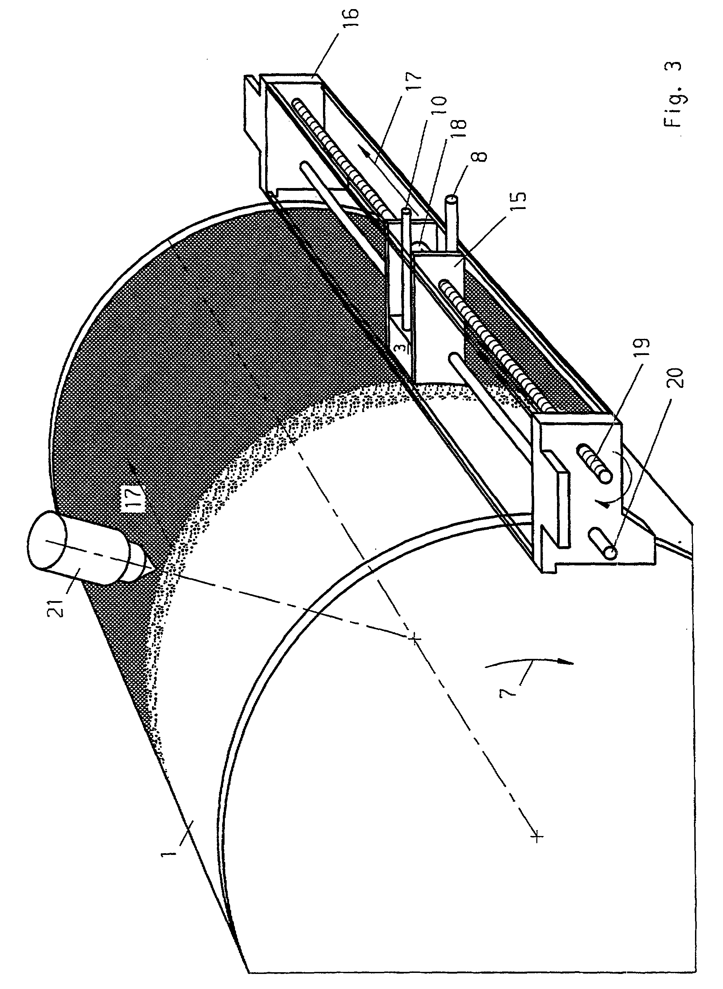

In Figur 1 ist ein Druckformzylinder 1, dessen Wirkflächen mittels Laserstrahlen beschrieben/bebildert werden, mit einer Einrichtung 2, die zum Entfernen der beim Beschreiben/Bebildern entstehenden Silikonpartikel dient, dargestellt. Die Einrichtung 2 ist in einer Arbeitsposition, in der sie in Wirkverbindung mit dem Druckformzylinder 1 steht, gezeigt und kann in radialer Richtung zum Druckformzylinder 1 verschoben und so aus der Arbeitsposition in eine Parkposition zurückgezogen werden. Die Einrichtung 2 erstreckt sich über die Breite des Druckformzylinders 1 und besteht aus einem Grundkörper 3. Der Grundkörper 3 weist eine der Peripherie des Druckformzylinders 1 folgende, diesem zugewandte Fläche 4 auf, welche mit der Auftrittsöffnung 6 einer Schlitzdüse 5 versehen ist. Die Schlitzdüse 5 ist mit einer Blasluftzuführung 8 verbunden und so im Grundkörper 3 angeordnet, daß der aus der Austrittsöffnung 6 austretende Blasluftstrahl gegen die Drehrichtung 7 des Druckformzylinders 1 gerichtet ist. Die Geometrie der Schlitzdüse 5 ist so ausgebildet, daß eine Überschallströmung realisiert wird.
Der Schlitzdüse 5 ist im Grundkörper 3 eine Absaugung 9 zugeordnet, die mit einer Unterdruckquelle 10 (Fig. 3) verbunden ist. Die Absaugung 9 weist einen Absaugkanal 11 auf, dessen Eintrittsöffnung 12 der Austrittsöffnung 6 der Schlitzdüse 5 entgegengerichtet ist und eine Breite aufweist, die mindestens der der Austrittsöffnung 6 entspricht. Die Absaugung 9 ist so gestaltet, daß der durch die Schlitzdüse 5 initiierte Blasluftstrom derart abgeführt wird, daß keine Blasluft in die Umgebung der Einrichtung 2 gelangt. Um das sicherzustellen, ist es auch möglich, der Eintrittsöffnung 12 eine weitere, der Absaugung 9 zugeordnete Eintrittsöffnung vorzusehen.
Werden die Wirkflächen des Druckformzylinders 1 beschrieben/bebildert, wird die Einrichtung 2 zum Entwickeln der Wirkflächen aus einer Rastposition in radialer Richtung zum Druckformzylinder 1 und damit in die in Fig. 1 gezeigte Arbeitsposition am Druckformzylinder 1 verbracht. Durch Beaufschlagen der Schlitzdüse 5 mit Blasluft werden vom aus der Austrittsöffnung 6 austretenden und entgegen der Drehrichtung 7 des Druckformzylinders 1 gerichtete Blasluftstrom die beim Beschreiben/Bebildern entstandenen Silikonpartikel oder anderen Verschmutzungen erfaßt bzw. von den Wirkflächen gelöst und abtransportiert, wobei durch die Absaugung 9 der die Verunreinigungen transportierende Blasluftstrom abgeführt wird.
Um zu sichern, daß auch die lediglich beim Beschreiben/Bebildern angelösten Silikonpartikel vollständig entfernt werden, ist es möglich, wie in Fig. 2 gezeigt, im Grundkörper 3 der Austrittsöffnung 6 der Schlitzdüse 5 eine zwangsweise angetriebene Bürstenwalze 13 vorzuordnen. Durch die zwangsweise in Umlaufrichtung 14 angetriebene Bürstenwalze 13 werden die von dem aus der Schlitzdüse 5 austretenden Blasluftstrom nicht abtransportierten Silikonpartikel gelöst, in den Bereich der Austrittsöffnung 6 gefördert, nachfolgend von dem Blasluftstrom erfaßt und durch die Absaugung 9 abgeführt.
In Fig. 3 ist eine weitere Ausführungsform perspektivisch dargestellt In dieser Ausführungsform sind der die Schlitzdüse 5 und die Absaugung 9 und gegebenenfalls einer der Schlitzdüse 5 vorgeordnete Bürstenwalze 13 enthaltende Grundkörper 3 der Einrichtung 2 in einem Schlitten 15 aufgenommen, der in einem Gestell 16 in axialer Richtung 17 des Druckformzylinders 1 verschiebbar gelagert ist.
Das Gestell 16 und damit der Schlitten 15 mit der Einrichtung 2 können aus der in Figur 3 gezeigten Arbeitsposition in radialer Richtung zum Druckformzylinder 1 verschoben und so in eine vom Druckformzylinder 1 entfernte Rastposition zurückgezogen werden.
Der Schlitten 15 kann z.B. mittels eines Schraubengetriebes in axialer Richtung verschoben werden. Dazu ist eine Gewindemutter 18 im Schlitten 15 drehfest angeordnet, in welche eine Gewindespindel 19 eingreift, die im Gestell 16 gelagert und durch nicht dargestellte Mittel angetrieben wird. Ist die Einrichtung 2 neben der Schlitzdüse 5 und der Absaugung 9 mit einer Bürstenwalze 13 versehen, kann der Antrieb der Bürstenwalze 13 z.B. mittels einer im Gestell 16 gelagerten und mit einem nicht dargestellten Antrieb in Verbindung stehenden Keilwelle 20 erfolgen.
In Figur 3 ist eine Einrichtung 21 zum Beschreiben/Bebildern der Wirkflächen des Druckformzylinders 1 dargestellt, die innerhalb eines Arbeitszyklus in axialer Richtung 17 am Druckformzylinder 1 entlang geführt wird, wobei der Druckformzylinder 1 in Drehrichtung 7 umläuft. Parallel zur Einrichtung 21 wird der Schlitten 15 und damit die Einrichtung 2 zum Entwickeln der durch die Einrichtung 21 beschriebenen/bebilderten Wirkflächen mitgeführt, wobei das Entfernen der Silikonpartikel oder sonstigen Verschmutzungen analog zu den Ausführungsformen gem. Figuren 1 und 2 erfolgt.

### Aufstellung der verwendeten Bezugszeichen

- 1: Druckformzylinder
- 2: Einrichtung zum Entwickein
- 3: Grundkörper
- 4: Fläche
- 5: Schlitzdüse
- 6: Austrittsöffnung
- 7: Drehrichtung
- 8: Blasluftzuführung
- 9: Absaugung
- 10: Unterdruckquelle
- 11: Absaugkanal
- 12: Eintriffsöffnung
- 13: Bürstenwalze
- 14: Umlaufrichtung
- 15: Schlitten
- 16: Gestell
- 17: axiale Richtung
- 18: Gewindemutter
- 19: Gewindespindel
- 20: Keilwelle
- 21: Einrichtung zum Beschreiben/Bebildern

## Patentansprüche

1. Einrichtung zum Entwickeln zylindrischer Oberflächen in Druckmaschinen
- mit mindestens einer integrierten Einrichtung (21) zum Beschreiben/Bebildern von Wirkflächen eines Druckformzylinders (1),
- die Einrichtung (2) zum Entwickeln der Wirkflächen des Druckformzylinders (1) ist wahlweise in eine Arbeitsposition am Druckformzylinder (1) oder in eine von diesem entfernte Rastposition verbringbar ausgeführt,
- die Einrichtung (2) weist einen Grundkörper (3) mit einer einen entgegen der Drehrichtung (7) des Druckformzylinders (1) gerichteten Blasluftstrom erzeugenden Schlitzdüse (5),
- und eine in einem Abstand zur Schlitzdüse (5) vorgesehene, den Blasluftstrom abführende Absaugung (9) auf.

2. Einrichtung nach Anspruch 1 mit einer eine Überschallströmung erzeugenden Schlitzdüse (5).

3. Einrichtung nach Anspruch 1 mit einer der Schlitzdüse (5) zugeordneten Blasluftzuführung (8) und einer der Absaugung (9) zugeordneten Unterdruckquelle (10).

4. Einrichtung nach Anspruch 1 mit einer sich in axialer Richtung (17) entlang dem Druckformzylinder (1) erstreckenden Schlitzdüse (5).

5. Einrichtung nach Anspruch 1 mit einer der Schlitzdüse (5) vorgeordneten, zwangsweise antreibbaren Bürstenwalze (13).

6. Einrichtung nach Anspruch 1 und 5 mit einer im Reversbetrieb betreibbaren Bürstenwalze (13).

7. Einrichtung nach Anspruch 1 bei der der die Schlitzdüse (5) und die Absaugung (9) enthaltende Grundkörper (3) in einem Schlitten (15) angeordnet ist,
- der Schlitten (15) ist synchron mit der Einrichtung (21) zum Beschreiben/Bebildern der Wirkflächen in axialer Richtung (17) des Druckformzylinders (1) verbringbar ausgeführt.

8. Einrichtung nach Anspruch 7 bei der der Schlitten (15) in einem Gestell (16) geführt ist und das Gestell (16) in radialer Richtung zum Druckformzylinder (1) oder von diesem weg verbringbar ausgeführt ist.

9. Einrichtung nach Anspruch 7 bei der der Schlitzdüse (5) eine zwangsweise antreibbare Bürstenwalze (13) vorgeordnet ist.

10. Einrichtung nach Anspruch 7 und 9 bei der die Bürstenwalze (13) im Reversbetrieb antreibbar ist.

## Claims

1. Equipment for designing cylindrical surfaces in printing machines
- with at least one integrated device (21) for describing/depicting effective surfaces of a printing cylinder (1),
- the device (2) for designing the effective surfaces of the printing cylinder (1) is constructed to be selectably movable into a working position at the printing cylinder (1) or into a detent position remote therefrom, and
- the device (2) comprises a base body (3) with a slot nozzle (5) producing an air jet directed against the rotational direction of the printing cylinder (1)
- and a suction means (9) provided at a spacing from the slot nozzle (5) and conducting the air jet away.

2. Equipment according to claim 1 with a slot nozzle (5) producing an ultrasound current.

3. Equipment according to claim 1 with an air jet feed (8) associated with the slot nozzle (5) and an underpressure source (10) associated with the suction means (9).

4. Equipment according to claim 1 with a slot nozzle (5) extending in axial direction (17) along the printing cylinder (1).

5. Equipment according to claim 1 with a constrainedly drivable brush roller (13) arranged in front of the slot nozzle (5).

6. Equipment according to claims 1 and 5 with a brush roller operable in reversible operation.

7. Equipment according to claim 1 in which the base body (3) containing the slot nozzle (5) and the suction means (9) is arranged in a slide (15) and the slide (15) is constructed to be movable in the axial direction (17) of the printing cylinder (1) synchronously with the device (21) for describing/depicting the effective surfaces.

8. Equipment according to claim 7 in which the slide (15) is guided in a frame (16) and the frame (16) is constructed to be movable in radial direction towards or away from the printing cylinder (1).

9. Equipment according to claim 7 in which a constrainedly drivable brush roller (13) is arranged in front of the slot nozzle (5).

10. Equipment according to claims 7 and 9 in which the brush roller (13) is drivable in reversible operation.

## Revendications

1. Installation pour développer les surfaces cylindriques de machines d'impression, comprenant
- au moins une installation intégrée (21) pour écrire/former des signes de surfaces actives d'un cylindre gravé d'impression (1),
- l'installation (2) pour développer les surfaces actives du cylindre gravé d'impression (1), pouvant être amenée sélectivement dans une position de travail contre le cylindre gravé d'impression (1) ou dans une position de repos éloignée du cylindre,
- l'installation (2) comprenant un corps de base (3) avec une buse à fente (5) générant un jet d'air de soufflage dirigé dans la direction opposée (7) du cylindre gravé d'impression (1), et
- une aspiration (9) prévue à une certaine distance de la buse à fente (5) pour évacuer le flux d'air.

2. Installation selon la revendication 1, comprenant
une buse à fente (5) générant un écoulement supersonique.

3. Installation selon la revendication 1,
comprenant un guidage d'air de soufflage (8) associé à la buse à fente (5) et une source à dépression (10) associée à l'aspiration (9).

4. Installation selon la revendication 1, comprenant
une fente à buse (5) qui s'étend dans la direction axiale (17), le long du cylindre gravé d'impression (1).

5. Installation selon la revendication 1, comprenant
un cylindre à brosse (13) entraîné de force, en amont de la buse à fente (5).

6. Installation selon l'une quelconque des revendications 1 et 5, comprenant
un cylindre à brosse (13) entraîné de manière réversible.

7. Installation selon la revendication 1, dans laquelle
- la fente à buse (5) et le corps de base (3) comportant l'aspiration (9), sont montés sur un chariot (15),
- le chariot (15) est synchrone avec l'installation (21) pour écrire/former des signes de surfaces actives dans la direction axiale (17) du cylindre gravé d'impression (1).

8. Installation selon la revendication 7, dans laquelle
le chariot (15) est guidé dans un bâti (16) et ce bâti (16) peut être rapproché ou écarté du cylindre gravé d'impression (1) dans la direction radiale.

9. Installation selon la revendication 7, dans laquelle
la buse à fente (5) est précédée d'un cylindre à brosse (13) entraîné de force.

10. Installation selon l'une quelconque des revendications 7 et 9, dans laquelle
le cylindre à brosse (13) est entraîné de manière réversible.
